# EUROPÄISCHE PATENTSCHRIFT

(11) **EP 1 144 973 B1**
(45) Veröffentlichungstag und Bekanntmachung des Hinweises auf die Patenterteilung: **25.01.2006**
(21) Anmeldenummer: 99962107.1
(22) Anmeldetag: 26.11.1999
(51) Int. Cl.: G01L 9/00, G03F 9/00, H01L 23/544

(54) **VERFAHREN ZUR ERZEUGUNG VON JUSTAGESTRUKTUREN IN HALBLEITERSUBSTRATEN**
METHOD OF PRODUCING CALIBRATION STRUCTURES IN SEMICONDUCTOR SUBSTRATES
PROCEDE POUR PRODUIRE DES STRUCTURES D'ALIGNEMENT DANS DES SUBSTRATS A SEMI-CONDUCTEURS

(30) Priorität: 15.12.1998 DE 19857742; 25.03.1999 DE 19913612
(43) Veröffentlichungstag der Anmeldung: 17.10.2001
(73) Patentinhaber: Fraunhofer-Gesellschaft zur Förderung der angewandten Forschung e.V., 80686 München (DE)
(72) Erfinder: NEUMEIER, Karl, D-82008 Unterhaching (DE); BOLLMANN, Dieter, D-81475 München (DE)
(74) Vertreter: Gagel, Roland
(86) Internationale Anmeldenummer: PCT/DE1999/003796
(87) Internationale Veröffentlichungsnummer: WO 2000/036383

(56) Entgegenhaltungen:
- DE-A- 4 223 455
- DE-C- 19 543 893
- US-A- 5 266 511

## Beschreibung

Die Erfindung betrifft ein Verfahren zur Erzeugung von Justagestrukturen in Halbleitersubstraten bei der Herstellung von Bauelementen, insbesondere von mikromechanischen Systemen mit integrierter Halbleiterelektronik. Das erfindungsgemäße Verfahren bietet besondere Vorteile beim Einsatz von Fotolithographie-Techniken bei der Bearbeitung von Siliziumwafern.

Bei der Herstellung von Halbleiterbauelementen oder von Sensorsystemen mit mikroelektronischen und mikromechanischen Komponenten werden in der Regel mehrere Schichten unterschiedlicher Funktion auf einer Halbleiterscheibe übereinander gebracht und strukturiert. Für die korrekte Funktionsweise des späteren Bauelementes müssen die Strukturen der einzelnen Schichten eine vorgegebene Lage zu den jeweils darunterliegenden Strukturen aufweisen. Die Strukturierung der Schichten erfolgt in der Regel mittels einer Lithographie-Technik, bei der die eingesetzten Belichtungsgeräte, wie beispielsweise Stepper oder Kontaktbelichter, mit den entsprechenden Masken exakt relativ zur zu belichtenden Schicht bzw. bereits vorhandenen Struktur positioniert werden müssen. Die Positionierung erfolgt mit Hilfe von Justagemarken. Die Erzeugung dieser Justagemarken oder -strukturen bildet den Gegenstand der vorliegenden Erfindung.

Ein bevorzugtes Anwendungsgebiet des erfindungsgemäßen Verfahrens betrifft die Herstellung von mikroelektronisch integrierten Sensoren oder Aktoren. Mikroelektronisch integrierte Sensoren messen einen physikalischen oder chemischen Zustand der Umwelt und verarbeiten ihn zu einem elektrischen Signal. Mikroelektronisch integrierte Aktoren wandeln ein elektrisches Signal in eine mechanische Bewegung oder ein akustisches Signal um.

Als Beispiel sei ein Drucksensor angeführt, bei dem eine Siliziumschicht über einem Hohlraum nach dem Prinzip eines Dosenbarometers als Membran dient. Beispiele für Drucksensoren und deren Herstellung sind aus der DE 37 43 080 A1 bekannt. Ein integrierter Meßwandler erfaßt die Bewegung oder den Biegezustand der Membran und stellt ein entsprechendes elektrisches Signal bereit. Diese Sensoren, die einen Hohlraum unter einer Halbleiterschicht aufweisen, sind auch für die empfindliche Messung von Temperatur, Strahlung, mechanischer Bewegung (Schwingung, Schall, Beschleunigung und Drehung) sowie der dynamischen oder chemischen Eigenschaften (z.B. Fluidität, Viskosität, Durchfluß, pH-Wert, elektrochemisches Potential) des umgebenden Mediums geeignet.

Der Hohlraum unter der Membran kann, wie im Beispiel eines Drucksensors, evakuiert sein oder ein beliebiges Medium, d.h. ein Gas, eine Flüssigkeit oder ein Festkörpermaterial enthalten, soweit dieses Medium mit der anzuwendenden Herstellungstechnologie, insbesondere mit den dabei auftretenden hohen Temperaturen, verträglich ist.

Die Membran besteht in vielen Fällen aus einer monokristallinen Siliziumschicht, weil deren physikalische Eigenschaften sehr gut reproduzierbar und bekannt sind. Die Siliziumschicht kann eine monokristalline oder eine abgeschiedene und rekristallisierte Siliziumschicht sein. Für spezielle Anwendungen kann die Membran auch aus anderen Formen des Siliziums, wie amorphem oder Polysilizium, aus einem anderen Halbleiter, wie Germanium, Galliumarsenid oder andere III-V Halbleiter, oder einem Isolator, wie z.B. Siliziumdioxid, Siliziumnitrid, Tantaloxid oder Titannitrid bestehen, soweit diese Stoffe mit der anzuwendenden Technologie verträglich sind.

Der Meßwandler zur Erfassung des Biegezustandes der Membran setzt sich beispielsweise aus einer Anordnung von piezoresistiven Widerständen zusammen, welche die aus der Durchbiegung resultierende mechanische Spannung in der Silizium-Membran in elektrische Signale umwandeln. Diese Signale können von einer in der gleichen Siliziumschicht hergestellten mikroelektronischen Schaltung verstärkt, verarbeitet, gegenüber Störeinflüssen kompensiert, in analoge oder digitale Form gewandelt und aufbereitet werden. Die Meßwandler können auch aus Dehnungsmeßstreifen, piezoelektrischen, kapazitiven oder chemisch-elektrischen Wandlern bestehen. Die Schaltung und die Meßwandler können je nach Anwendung in einer geeigneten mikroelektronischen Technologie (Bipolar, BICMOS, CMOS usw.) gefertigt werden.

Bei der Herstellung eines derartigen Sensors, der sich aus verschiedenen Schichten bzw. Ebenen zusammensetzt, in CMOS-Technologie wird zunächst die erste Ebene unjustiert belichtet, da mit blanken Siliziumwafern begonnen wird. Das Belichtungsgerät, z.B. ein Stepper oder Kontaktbelichter, orientiert sich hierbei nur grob im Bereich von +/- 100 µm durch mechanischen Anschlag an den Rändern des Wafers. Alle folgenden Ebenen werden direkt oder indirekt mit hoher Genauigkeit nach dieser ersten Ebene justiert. Bei einem Halbleiterprozeß mit Strukturgrößen von 0,8 µm muß diese Justage beispielsweise mit einer Genauigkeit von +/- 0,3 *µ*m erfolgen. Um die Genauigkeit des Steppers auch für die Positionierung der Meßwandler relativ zu den Hohlräumen nutzen zu können, müssen während der Belichtung der ersten CMOS-Ebene Justagemarken für den Stepper erkennbar sein, die vorangehend bei der Definition der Hohlräume erzeugt wurden. Ziel des Einsatzes der Justagemarken ist es, die Meßwandler mit der in CMOS-Prozessen üblichen Genauigkeit zu positionieren. Simulationsrechnungen nach der FEM-Methode haben ergeben, daß mit dieser Genauigkeit die Streuung der elektrischen Ausgangssignale kleiner als 2% des Meßwertes bleiben. Die restliche Fertigungsstreuung kann durch eine auf dem Chip integrierte Logik kompensiert werden.

Zur Erzeugung der Hohlräume unter der Membran kann beispielsweise auf einem Wafer eine dünne Oxidschicht abgeschieden werden. Mittels einer Fotolithographie-Technik werden durch Ätzen großflächige Vertiefungen in dieser Oxidschicht erzeugt, die die Hohlräume für die Sensoren festlegen. Anschließend wird ein zweiter Siliziumwafer durch Bonden mit dem ersten Wafer verbunden, so daß an Stelle der Vertiefungen die Hohlräume entstehen. Danach wird der erste Wafer von der Rückseite her gedünnt, so daß eine Oberfläche der Silizium- bzw. SOI-Schicht freiliegt. Der zweite Wafer übernimmt die Rolle als Trägerwafer. Der über dem Hohlraum liegende Teil der Silizium-Schicht wird zur Membran des Sensors. Die freiliegende Oberfläche der Silizium-Schicht wird in der anschließenden Halbleiterfertigung zur Integration der Meßwandler oder weiterer mikroelektronischer Schaltungsteile weiter prozessiert.

Aus der DE 195 43 893 C1 ist ein Verfahren zum Ausrichten von in einem Substrat zu erzeugenden Strukturen bekannt, bei dem zur Justage der CMOS-Ebenen bei dem oben skizzierten Herstellungsverfahren relativ zu den Hohlräumen Justagemarken verwendet werden. Bei diesem Verfahren werden die Justagemarken in die Oberfläche des ersten Wafers als Gräben (sog. Trenches) geätzt und nachfolgend mit einem geeigneten Material aufgefüllt. Die vom Stepper benötigten Justagemarken und Linien werden dabei nachgebildet. Die Gräben erstrecken sich bis zu einer Tiefe in den ersten Wafer, die zumindest der Restdicke des in einem späteren Schritt gedünnten Wafers entspricht, so daß sie die gedünnte Siliziumschicht vollständig durchdringen. Die Marken sind daher nach dem Rückdünnen des Wafers auf der neuen Oberfläche gut sichtbar. Die Anforderungen an die Justierbarkeit sind damit erfüllt.

Ein Nachteil dieses Trench-Verfahrens zur Erzeugung der Justiermarken ist die Notwendigkeit von zusätzlichen Prozeßschritten. Diese Prozeßschritte sind einerseits erforderlich, um die größere Tiefe der Gräben im vergleich zu den Hohlraumstrukturen zu erzeugen. Zum anderen müssen die Gräben zusätzlich mit einem geeigneten Material aufgefüllt werden.

Ein weiterer Nachteil dieses Verfahrens besteht im Erfordernis eines speziellen Trench-Ätzverfahrens, um die Gräben im Siliziumwafer mit einer ausreichenden Flankensteilheit erzeugen zu können. Weiterhin wird eine aufwendige Maskierungsschicht benötigt, welche dem intensiven Plasmaätzen widerstehen muß und danach entfernt wird.

Ein besonderer Nachteil besteht darin, daß das vollständige Durchätzen der SOI-Schicht mit anschließendem Auffüllen eine Schwächung der mechanischen Eigenschaften der Schicht bewirkt und mechanische Spannungen bei nachfolgenden Temperaturschritten erzeugt. Da die Hohlräume und die folgenden CMOS-Ebenen auf eine Hilfsebene justiert werden, wird die resultierende Justagegenauigkeit verschlechtert.

Die US 5 266 511 A offenbart ein Verfahren zur Herstellung dreidimensionaler Schaltkreise. Hierbei sind auf einem ersten Substrat mehrere Schichten aufgebracht. In einer der Schichten wird eine Justagemarkierung gebildet. Anschließende wird ein zweites Substrat mit dem ersten Substrat verbunden und gedünnt. Durch das Entfernen bestimmter Bereiche des zweiten Substrates wird die Justagemarkierung freigelegt.

Die DE 42 23 455 A1 offenbart ein Verfahren zur Erzeugung von Justagestrukturen in Halbleitersubstraten zur Herstellung von Bauelementen, bei dem zunächst eine auf einem ersten Substrat ausgebildete erste Schicht zur Bildung von ersten Bereichen für die Funktion der Bauelemente und von zweiten Bereichen als Justagestrukturen strukturiert wird. Die zweiten Bereiche durchdringen die erste Schicht vollständig und weisen einen Brechungsindex auf, der sich vom Brechungsindex angrenzender Bereiche unterscheidet. Das erste Substrat wird mit einem zweiten Substrat verbunden, so dass die erste Schicht zwischen den beiden Substraten liegt. Im zweiten Substrat sind Beobachtungsfenster angeordnet, die über den Justagestrukturen der ersten Schicht liegen. Anschließend wird das zweite Substrat bis auf eine Restdicke gedünnt, so dass die Justagestrukturen über die Beobachtungsfenster freigelegt werden.

Auch bei den beiden letztgenannten Verfahren tritt somit eine deutliche Schwächung der mechanischen Eigenschaften des zweiten Substrates auf.

Die Aufgabe der vorliegenden Erfindung besteht darin, ein Verfahren zur Erzeugung von Justagestrukturen bei der Herstellung von Bauelementen anzugeben, die keine Schwächung der mechanischen Eigenschaften tragender Schichten hervorrufen, und das ohne zusätzliche Prozeßschritte oder aufwendige Ätzverfahren in den Herstellungsprozeß integriert werden kann.

Die Aufgabe wird mit dem Verfahren nach Anspruch 1 gelöst. Vorteilhafte Ausgestaltungen oder Weiterbildungen des Verfahrens sind Gegenstand der abhängige Ansprüche.

Die Erfindung bezieht sich hierbei vorzugsweise auf die Herstellung von Justagestrukturen für die Fotolithographie in Siliziumwafern. Die Strukturen beruhen auf einer lokalen Änderung des Brechungsindex oder der Dämpfung innerhalb oder unterhalb einer dünnen Siliziumschicht, so daß die Topographie der Waferoberfläche nicht verändert oder beeinflußt wird. Die Justagestrukturen sind für ein Belichtungsgerät im roten oder infraroten Licht und insbesondere bei Dunkelfeldbeleuchtung sichtbar.

Das erfindungsgemäße Verfahren ist zum Beispiel für die Herstellung von mikroelektronisch integrierten Sensoren und Aktoren auf der Grundlage von SOI-Wafern mit vergrabenen Hohlräumen und integrierten elektronischen Auswerteschaltungen in CMOS-Technologie geeignet.

Bei dem Verfahren wird ein erstes Substrat, vorzugsweise ein Wafer, bereitgestellt, auf dem eine erste Schicht ausgebildet ist. Die erste Schicht, beispielsweise eine Oxidschicht, wird zur Bildung von ersten Bereichen strukturiert, die für die Funktion der Bauelemente erforderlich sind. Bei Drucksensoren stellen diese ersten Bereiche Vertiefungen dar, die die Hohlräume der späteren Drucksensoren bilden. Vor, nach oder gleichzeitig mit dieser Strukturierung der ersten Bereiche werden in der ersten Schicht zweite Bereiche gebildet, die die Justagestrukturen darstellen. Diese zweiten Bereiche durchdringen die erste Schicht vollständig. Gegebenenfalls können sie sich bis zu einer gewissen Tiefe in das unter der ersten Schicht liegende erste Substrat erstrecken. Die Tiefe muß jedoch geringer sein als die Dicke des ersten Substrates. Wird das erste Substrat in einem weiteren Schritt von der Rückseite gedünnt, so muß die Tiefe der zweiten Bereiche im ersten Substrat geringer sein als die Dicke des gedünnten ersten Substrates. Die zweiten Bereiche weisen einen Brechungsindex auf, der sich vom Brechungsindex angrenzender Bereiche unterscheidet. Dies kann einerseits dadurch erreicht werden, daß die Bereiche als Vertiefungen ausgebildet werden, die bei den nachfolgenden Schritten einen evakuierten oder mit einem Gas gefüllten Hohlraum bilden. Die Vertiefungen können jedoch in einem weiteren Schritt auch mit einem Material aufgefüllt werden, das einen anderen Brechungsindex als das umgebende Material aufweist. Vorzugsweise wird hierbei ein Material verwendet, dessen Unterschied im Brechungsindex zum umgebenden Material größer ist als der Brechungsindex-Unterschied zwischen Luft oder Vakuum und dem umgebenden Material. Im Falle einer Siliziumoxidschicht als erster Schicht auf einem Siliziumwafer kann beispielsweise ein Metall wie Wolfram als ein derartiges Material eingesetzt werden. Ein Bereich mit unterschiedlichem Brechungsindex kann natürlich auch durch Implantation von geeigneten Ionen oder Atomen in die erste Schicht erzeugt werden.
Nach dem Erzeugen der ersten und zweiten Bereiche wird das erste Substrat mit einem zweiten Substrat verbunden, so daß die erste Schicht zwischen den beiden Substraten liegt. Geeignete Verbindungstechniken sind dem Fachmann bekannt. Anschließend wird entweder das erste oder das zweite Substrat von der offenliegenden Seite bis auf eine Restdicke gedünnt, wobei die die Justagestrukturen bildenden zweiten Bereiche durch das Dünnen des ersten oder des zweiten Substrates nicht freigelegt werden. Die Substratschicht mit dieser Restdicke bildet beispielsweise die Membran bei einem Drucksensor. Das Dünnen kann in bekannter Weise mittels Schleifen, Polieren, CMP oder Ätzen erfolgen.

In einer bevorzugten Ausführungsform des erfindungsgemäßen Verfahrens, bei dem die ersten für die Funktion des Bauelementes erforderlichen Bereiche Vertiefungen in der ersten Schicht darstellen, werden die zweiten Bereiche im gleichen Verfahrensschritt ebenfalls als Vertiefungen in der ersten Schicht erzeugt. Hierdurch können mit dem für die ersten Bereiche erforderlichen Ätzprozeß gleichzeitig auch die Justagestrukturen bereitgestellt werden. Es ist somit kein zusätzlicher Prozeßschritt notwendig.

Das erfindungsgemäße Verfahren zur Justage vermeidet die bisher notwendige Modifikation zum Schutz der nach dem Bonden und Dünnen freiliegenden Siliziumoberfläche. Es können daher keine nachteiligen Verunreinigungen des Siliziums auftreten.

Die zum Justieren notwendigen Strukturen, wie Kreuze und Liniengruppen, werden gleichzeitig mit den Funktionsstrukturen des Bauelementes, z.B. den Hohlräumen bei einem Drucksensor, oder in einem zusätzlichen Schritt durch Strukturieren der ersten Schicht erzeugt.

Bei der Herstellung der Justagestrukturen mit dem erfindungsgemäßen Verfahren ist die gedünnte Substratschicht über den Justagestrukturen, im Vergleich zu den Schichtbereichen über den als Sensor verwendeten Hohlräumen, steif, so daß der zu messende Effekt durch die Justagestrukturen nicht beeinflußt wird. Es tritt keine Schwächung der mechanischen Eigenschaften der Schicht durch die Justagestrukturen ein.

Falls vom Belichtungsgerät flächige Justagemarken gefordert werden, kann die Kontur dieser Flächen durch nebeneinander liegende Rillen nachgebildet werden. Die Breite der langgestreckten Rillen liegt vorzugsweise in der Größenordnung der Dicke der ersten Schicht oder darunter. Es sind auch flächige Justagemarken möglich, solange die Steifigkeit der gedünnten Substratschicht nicht beeinträchtigt wird.

Da die Justagemarken zusammen mit den ersten Bereichen durch die gleiche Lithographiemaske belichtet werden, erhöht sich die Genauigkeit der Position der Justagemarken und damit, beispielsweise bei Drucksensoren, die Genauigkeit der Anordnung der mit Hilfe der Justagemarken zu positionierenden Meßwandler zu den Hohlräumen.

Neben der bisher bekannten Nutzung der Infrarotmikroskopie in Transmission kann zur Erkennung der gemäß der Erfindung erzeugten Justagestrukturen auch das Auflichtverfahren (in Reflexion) genutzt werden. In dünnen Schichten ist das als Wafermaterial in der Regel eingesetzte Silizium für rotes und infrarotes Licht durchlässig. Eine 2-10 µm dicke Siliziumschicht erscheint dem menschlichen Auge im Gegenlicht dunkelbraun. Die bei Drucksensoren verwendeten Hohlräume sind im Mikroskop im (breitbandigen) Auflicht mit dem Auge nicht erkennbar. Lediglich bei Dunkelfeldbeleuchtung sind die Hohlräume sichtbar. Bei zunehmender Wellenlänge steigt die Transmissivität von Silizium drastisch an. Für die Beleuchtung der Justagemarken ist der Einsatz von Glühlampen, Gasentladungslampen oder Lasern möglich. Durch optische Filter im Strahlengang kann ein schmalbandiger Bereich bei z.B. 800 nm Wellenlänge aus dem Spektralbereich dieser Lampen ausgewählt werden. Als Empfänger wird vorzugsweise eine CCD-Kamera benutzt, die im genannten Bereich noch ausreichend empfindlich ist. Bei einer geeigneten Kombination von Lichtquelle, Filter, Schichtdicke und Kamera lassen sich die Strukturen im Oxid (als erster Schicht) unter der SOI-Schicht deutlich nachweisen.

Weil Silizium z.B. bei 800 nm mit n = 3,7 einen sehr hohen Brechungsindex hat, wird ein großer Teil (R₁ = 33%) des einfallenden Lichtes bereits an der Oberfläche reflektiert. Der Absorptionskoeffizient von undotiertem Silizium bei dieser Wellenlänge beträgt etwa 0,1 µm⁻¹ und sinkt mit steigender Wellenlänge. Wenn das Licht zweimal die Schichtdicke von z.B. 5 µm durchdringen muß, ist seine Intensität auf den 1/e ten Teil gedämpft worden. Beim Austreten vom Silizium an Luft wird das Licht noch einmal um den reflektieren Teil geschwächt. An der unteren Grenzfläche vom Silizium zum Oxid führt der Sprung im Brechungsindex (von n_{Si} = 3,7 auf n_{Oxid} = 1,5) ebenfalls zu einer Reflexion von R₂ = (n_{Si} - n_{Oxid})² / (n_{Si} + n_{Oxid})² = 18%. Die insgesamt reflektierte Intensität ist damit I_{ges} = (1-R₁) * (1/e) * R₂ * (1-R₁) = 3%. Da dieses Nutzsignal schwächer als der Reflex an der ersten Oberfläche ist, sollte bevorzugt mit Dunkelfeldbeleuchtung gearbeitet werden.

Um einen ausreichenden Kontrast zu erzeugen, muß eine Struktur im Vergleich zur Umgebung einen deutlichen Unterschied im Brechungsindex oder im Absorptionsindex aufweisen oder die Struktur streut das Licht in nennenswertem Maße aus seiner ursprünglichen Richtung.

Im beschriebenen Verfahren wird der Kontrast durch das Entfernen des Oxides von der unteren Grenzfläche der Siliziumschicht erzeugt. Dann ist die Reflexion am Übergang von Silizium nach Luft bzw. Vakuum größer R^{*}₂ = 33%. Die insgesamt reflektierte Intensität wird damit I^{*}_{ges} = 5,5%. Die Struktur erscheint also heller als die Umgebung. Zusätzlich wirken die Kanten der Strukturen als Streuzentren, welche bei Dunkelfeldbeleuchtung deutlich hell erscheinen.

Als Weiterbildung des erfindungsgemäßen Verfahrens ist die Füllung der zur Justage verwendeten Hohlräume mit einem Material möglich, das den Kontrast erhöht. Mit einer Füllung aus Metall, bevorzugt Wolfram, ist eine Steigerung des zweiten Reflexes auf 90% möglich. Diese, wie auch die folgenden Verbesserungen werden allerdings mit einer zusätzlichen Lithographieebene erkauft, da die für den Sensor benutzten Hohlräume nicht gefüllt oder verändert werden dürfen und daher vorher mit Fotolack zu schützen sind.

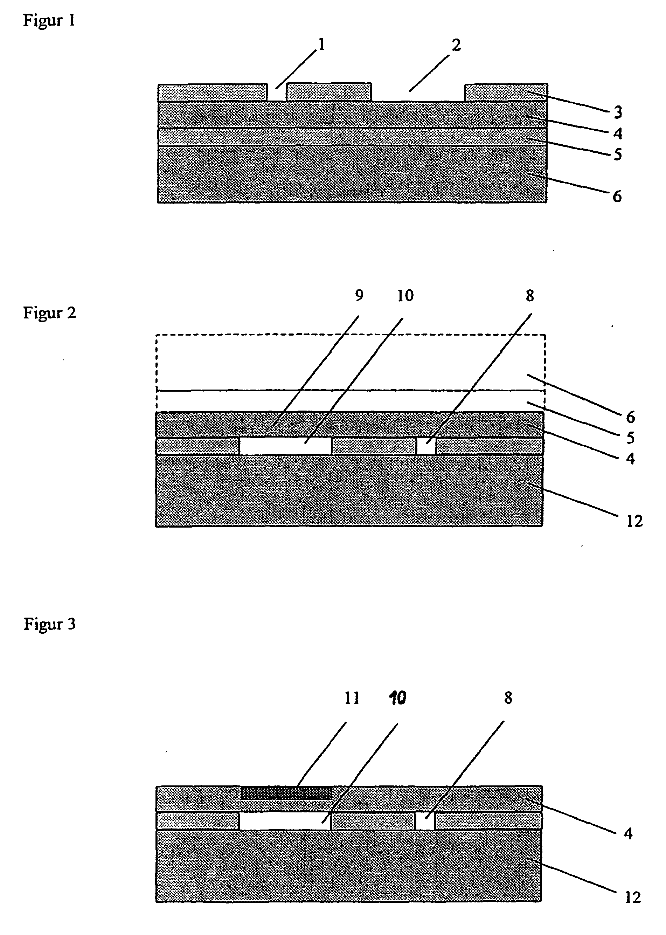

Eine weitere Variante des erfindungsgemäßen Verfahrens ist das Tieferätzen der Hohlräume in die Siliziumschicht hinein, wie beispielsweise in Figur 3 zu erkennen. Weil das strukturierte Oxid bei dieser Variante als selbstjustierende Maske benutzt wird, tritt kein Verlust an Justagegenauigkeit auf.
Der kontraststeigernde Effekt kann durch mehrere Wege erzielt werden.

Die Siliziumschicht kann einerseits durch Ätzen so weit gedünnt werden, daß die Absorption im Material deutlich geringer wird. Sinnvoll erscheint eine Halbierung der Schichtdicke. Dabei wird auch die im Dunkelfeld sichtbare Streuwirkung der Kanten erhöht. Dies bedeutet, daß bei in der Regel vorgegebener Schichtdicke der Siliziumschicht die Vertiefungen für die Justagestrukturen eine bestimmte Tiefe erreichen müssen.

Auch eine nur geringfügige Ätzung der Siliziumschicht kann einen deutlichen Kontrast hervorrufen, wenn die geätzte Stufe einer Änderung der optischen Weglänge im Silizium von einer halben Wellenlänge des zur Erkennung der Strukturen eingesetzten Zentralwellenlänge entspricht. Dies ist bei Mikroskopen als Phasenkontrastverfahren oder Phaseshifting bekannt. Eine Stufenhöhe von etwa 0,11 µm bewirkt eine auslöschende Interferenz. Die erforderliche Voraussetzung des im wesentlichen monochromatischen Lichtes ist durch den Einsatz eines Infrarotfilters annähernd erfüllt. Durch Verwendung von Polarisationsfiltern kann der Kontrast nach dem Prinzip des Ellipsometers weiter gesteigert werden.

Der gleiche optische Effekt wie bei der Änderung der Dicke der Siliziumschicht bzw. der Tiefe der Justagestrukturen kann durch eine Ionenimplantation in die Siliziumschicht erzielt werden. Die strukturierte Oxidschicht wird hierbei als Maske für die Implantation genutzt. Durch geeignete Wahl der Eindringtiefe und Dosis wird der Brechungsindex des Siliziums in diesem Bereich gerade soweit geändert, daß sich die optische Weglänge um eine halbe Wellenlänge von der unveränderten Umgebung unterscheidet.

Anstelle einer Beleuchtungs-Wellenlänge von 800 nm kann auch eine andere Wellenlänge im Bereich von etwa 750 bis 1000 nm verwendet werden. Die Grenze zu kurzen Wellenlängen ist durch die erhöhte Absorption im Sichtbaren gegeben, zu längeren Wellenlängen durch die Empfindlichkeitskurve der Kamera. Der Absorptionskoeffizient von Silizium sinkt deutlich mit steigender Wellenlänge.

Bei der Wahl anderer Substratmaterialien ist der Fachmann in der Lage, entsprechend andere geeignete Beleuchtungswellenlängen aufzufinden.

Da sich die zur Justage verwendeten Hohlräume nicht in der gleichen Ebene wie die zu belichtenden Strukturen im Fotolack befinden, kann ein eventuell auftretender Parallaxenfehler durch einen lateralen Vorhalt in der Maske ausgeglichen werden.

Die Kontrolle der Lage der bei der Lithographie erzeugten Strukturen relativ zu den Justagemarken kann wie üblich im Mikroskop erfolgen, wenn Dunkelfeldbeleuchtung angewendet wird.

Bei der Herstellung der Silizium-Membran kann auch vorteilhaft SOI-Material (Silicon On Insulator) verwendet werden. Weil bei dem Prozeß des Dünnens eine selektive Ätze an der Siliziumoberfläche stoppt, kann hierbei die Dicke der Membran exakt eingehalten werden.

Das erfindungsgemäße Verfahren wird im folgenden an einem Ausführungsbeispiel in Verbindung mit den Zeichnungen nochmals veranschaulicht. Hierbei zeigen:
- Fig. 1-3: schematisch ein Beispiel für die Durchführung des erfindungsgemäßen Verfahrens; und
- Fig. 4-6: das Ergebnis von Varianten des erfindungsgemäßen Verfahrens.

Das Ausführungsbeispiel betrifft die Herstellung eines Drucksensors, wie er in der Beschreibungseinleitung erläutert wurde. Ein derartiger Drucksensor besteht aus einem Hohlraum (10) unter einer dünnen Siliziummembran (9), in der Wandlerelemente (11, Fig.3) zur Erfassung der Durchbiegung der Membran integriert sind.

Bei der Herstellung dieses Sensors wird im vorliegenden Ausführungsbeispiel zunächst ein SOI-Wafer bereitgestellt, der aus einem Substrat (6), einem vergrabenen Oxid (5) und einer dünnen Siliziumschicht (4) besteht. Auf dem SOI-Wafer wird eine etwa 1 µm dicke Oxidschicht (3) als thermisches Oxid oder Abscheideoxid erzeugt. Anschließend werden mittels einer Fotolithographie und nachfolgendem Ätzen, das als Trockenätzprozeß oder als Naßätzprozeß erfolgen kann, Vertiefungen (1 und 2) in dieser Oxidschicht erzeugt. Die großflächigen Vertiefungen (2) dienen später als Hohlraum für den Sensor, während die kleinen Vertiefungen (1) zur Justage dienen. Die laterale Struktur für die großflächigen Vertiefungen (2) wird daher durch die Funktion bzw. die gewünschten Eigenschaften des Sensors vorgegeben. Die kleinen Vertiefungen (1) werden entsprechend den vom Belichtungsgerät geforderten Geometrien der Justagemarken geformt. In der Regel sind dies linien- oder kreuzförmige Strukturen. Beide Arten von Vertiefungen werden über eine gemeinsame Lithographiemaske erzeugt, so daß sie eine exakte räumliche Beziehung zueinander haben. Die Tiefe der Vertiefungen entspricht bei diesem Beispiel der Dicke der Oxidschicht. In Figur 1 ist nur ein Ausschnitt aus dem Wafer dargestellt, der einem späteren Drucksensor entspricht.

Anschließend wird, wie in Figur 2 gezeigt, ein zweiter Siliziumwafer (12) (Bulk-Wafer) durch Bonden mit dem ersten Wafer verbunden (Silicon-fusionbonding). Damit werden die Vertiefungen (1, 2) zu Hohlräumen (8, 10). Danach werden die Trägerschicht (6) und die Oxidschicht (5) des SOI-Wafers mittels Schleifen, Polieren (auch CMP) oder Ätzen von der Rückseite entfernt. Der zweite Wafer (12) übernimmt damit die Rolle als Trägerwafer. Der über dem großflächigen Hohlraum (10) liegende Teil der Siliziumschicht (4) wird zur Membran (9) des Sensors. Die nach dem Entfernen der Trägerschicht (6) und der Oxidschicht (5) freiliegende Oberfläche der Siliziumschicht (4) kann in der folgenden Halbleiterfertigung prozessiert werden, um darin Wandlerelemente (11) wie beispielsweise piezoresistive Widerstände zu erzeugen. Hierbei kann die Position dieser Wandlerelemente relativ zu den großflächigen Hohlräumen (10) mit Hilfe der Justagemarken (8) und einem der oben angeführten optischen Belichtungsverfahren exakt eingehalten werden (siehe Figur 3).

Die Größe der Vertiefungen richtet sich nach dem geplanten Druckbereich des Sensors in Verbindung mit der Dicke der Siliziumschicht, die als Membran benutzt wird. Die erforderliche Geometrie, d.h. die laterale Form (quadratisch, länglich oder rund) der Hohlräume und die Position der Meßwandler, läßt sich mit den bekannten elastischen Materialeigenschaften von Silizium durch FEM-Simulation (Finite-Elemente-Methode) vorausberechnen und optimieren. Im Anwendungsbeispiel werden bei einer Dicke der Siliziumschicht von 5 µm quadratische Hohlräume von etwa 200 *µ*m Kantenlänge verwendet.

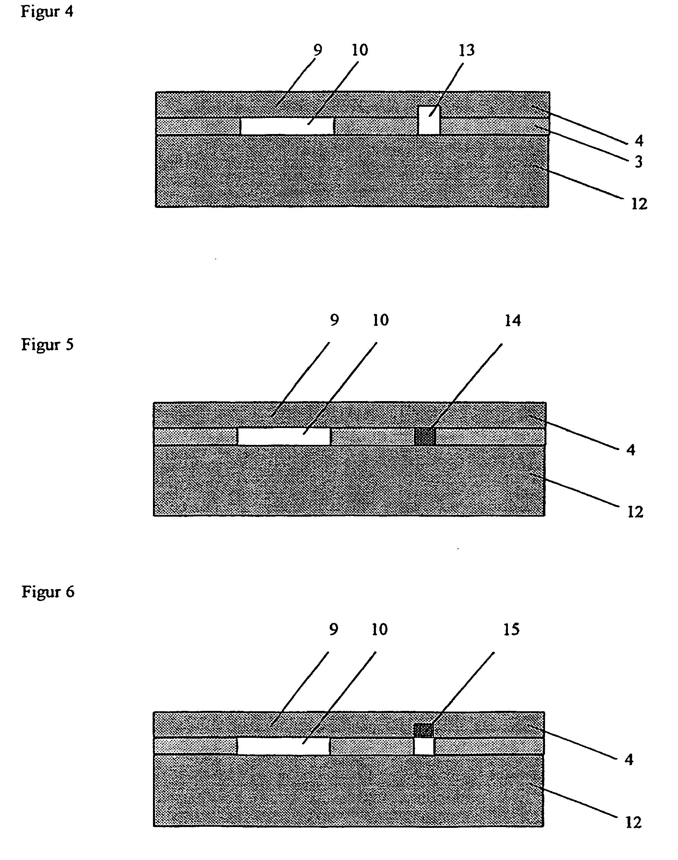

Figur 4 zeigt das Ergebnis einer Abwandlung des erfindungsgemäßen Verfahrens. Hierbei werden grundsätzlich die gleichen Verfahrensschritte durchgeführt wie bei dem Verfahren gemäß den Figuren 1 und 2. Gleiche Bezugszeichen bezeichnen bei dieser und den nachfolgenden Figuren die gleichen Elemente wie in den Figuren 1 und 2. Die Wandlerelemente sind in den Figuren 4 bis 6 nicht dargestellt.

Allerdings werden bei der Variante der Figur 4 die Vertiefungen für die Justagemarken tiefer geätzt als die Vertiefungen für die großflächigen Hohlräume (10). Dies erfordert zusätzliche Verfahrensschritte, bei denen die Vertiefungen für die großflächigen Hohlräume (10) mit einer Schutzschicht abgedeckt werden, so daß die Hohlräume (13) für die Justagemarken bis in das Siliziumsubstrat hinein geätzt werden können. Diese Schutzschicht muß nachfolgend wieder entfernt werden. Die dargestellte Variante hat den Vorteil einer besseren Erkennbarkeit der Justagemarken von der Oberfläche aus.

Figur 5 zeigt das Ergebnis einer weiteren Abwandlung des erfindungsgemäßen Verfahrens. Dabei werden vor dem Verbinden der beiden Wafer die als Justagemarken vorgesehenen Vertiefungen (1) mit einem Metall (14) aufgefüllt. Dies bewirkt eine Steigerung des Kontrastes, wie bereits weiter oben ausgeführt.

Figur 6 zeigt das Ergebnis einer weiteren Variante des erfindungsgemäßen Verfahrens. Hier wird die Erkennbarkeit der Justagestrukturen durch eine Ionenimplantation (15) in die Silizium-Schicht (4) verbessert. Die Vertiefungen (1) im Oxid (3) dienen dabei als Maske während der Implantation.

## Patentansprüche

1. Verfahren zur Erzeugung von Justagestrukturen in Halbleitersubstraten bei der Herstellung von Bauelementen, mit den Schritten:
- Bereitstellen eines ersten Substrates (4, 5, 6), auf dem eine erste Schicht (3) ausgebildet ist;
- Strukturieren der ersten Schicht (3) zur Bildung von ersten Bereichen (2), die für die Funktion der Bauelemente erforderlich sind;
- Verbinden des ersten Substrates (4, 5, 6) mit einem zweiten Substrat (12), so daß die erste Schicht (3) zwischen den beiden Substraten liegt; und
- Dünnen des ersten oder des zweiten Substrates bis auf eine Restdicke;
wobei die Justagestrukturen vor dem Verbinden des ersten Substrates (4, 5, 6) mit dem zweiten Substrat (12) als zweite Bereiche (1) gebildet werden, die die erste Schicht (3), nicht jedoch das erste Substrat (4) vollständig durchdringen, und einen Brechungsindex aufweisen, der sich vom Brechungsindex angrenzender Bereiche zur Erkennbarkeit der Justagestrukturen für ein Belichtungsgerät unterscheidet;
**dadurch gekennzeichnet,**
**dass** die die Justagestrukturen bildenden zweiten Bereiche (1) durch das Dünnen des ersten oder des zweiten Substrates nicht freigelegt werden.

2. Verfahren nach Anspruch 1,
**dadurch gekennzeichnet,**
**daß** die zweiten Bereiche (1) als Vertiefungen in der ersten Schicht (3) erzeugt werden, die nach dem Verbinden der beiden Substrate Hohlräume (8, 13) bilden.

3. Verfahren nach Anspruch 1,
**dadurch gekennzeichnet,**
**daß** die zweiten Bereiche (1) als Vertiefungen in der ersten Schicht (3) erzeugt werden, die vor dem Verbinden der beiden Substrate in einem weiteren Schritt mit einem Material (14) aufgefüllt werden, das einen größeren Unterschied im Brechungsindex zu den angrenzenden Bereichen aufweist als Luft.

4. Verfahren nach Anspruch 2 oder 3,
**dadurch gekennzeichnet,**
**daß** die ersten Bereiche (2) als Vertiefungen erzeugt werden, die nach dem Verbinden der beiden Substrate einen Hohlraum (10) bilden.

5. Verfahren nach Anspruch 4,
**dadurch gekennzeichnet,**
**daß** die Vertiefungen der zweiten Bereiche (1) im gleichen Verfahrensschritt wie die Vertiefungen der ersten Bereiche (2) gebildet werden.

6. Verfahren nach einem der Ansprüche 2 bis 4,
**dadurch gekennzeichnet,**
**daß** die Vertiefungen der zweiten Bereiche (1) bis in das erste Substrat (4, 5, 6) hinein erzeugt werden.

7. Verfahren nach Anspruch 6,
**dadurch gekennzeichnet,**
**daß** die Vertiefungen der zweiten Bereiche (1) bis zu einer Tiefe in das erste Substrat (4, 5, 6) hinein erzeugt werden, die im Substrat einer optischen Weglänge von einer halben Wellenlänge des für die Erkennung der Justagestrukturen einzusetzenden monochromatischen Lichtes entspricht.

8. Verfahren nach einem der Ansprüche 2 bis 5, **gekennzeichnet durch** folgenden weiteren Schritt vor dem Verbinden der beiden Substrate:
Ionenimplantation (15) in das erste Substrat (4, 5, 6) am Ort der Vertiefungen der zweiten Bereiche (1) bis in eine Tiefe, die im Substrat einer optischen Weglänge von einer halben Wellenlänge des für die Erkennung der Justagestrukturen einzusetzenden monochromatischen Lichtes entspricht, wobei die strukturierte erste Schicht (3) als Maske für die Ionenimplantation dient.

9. Verfahren nach einem der Ansprüche 2 bis 8,
**dadurch gekennzeichnet,**
**daß** flächige Justagestrukturen durch nebeneinander liegende rillenförmige Vertiefungen gebildet werden.

10. Verfahren nach einem der Ansprüche 1 bis 9,
**dadurch gekennzeichnet, daß** die erste Schicht (3) eine Oxid- und/oder Nitridschicht ist.

11. Verfahren nach einem der Ansprüche 1 bis 10,
**dadurch gekennzeichnet, daß** das erste und/oder zweite Substrat ein Silizium-Substrat ist.

12. Verfahren nach einem der Ansprüche 1 bis 10,
**dadurch gekennzeichnet, daß** das erste und/oder zweite Substrat ein SOI-Substrat ist.

13. Verfahren nach einem der Ansprüche 1 bis 12,
**dadurch gekennzeichnet, daß** das Dünnen mittels Schleifen, Polieren, CMP oder Ätzen erfolgt.

## Claims

1. Method of producing calibration structures in semiconductor substrates in the production of components, comprising the following steps:
- providing a first substrate (4, 5, 7) on which a first layer (3) is formed;
- structuring said first layer (3) for creating first areas (2) that are required for the function of the components;
- joining said first substrate (4, 5, 6) with a second substrate (12) such that said first layer (3) is enclosed between the two substrates; and
- thinning said first or said second substrate down to a residual thickness; wherein said calibration structures are formed as second areas (1) prior to joining said first substrate (4, 5, 6) with said second substrate (12), which second areas penetrate completely through said first layer (3) but not through said first substrate (4) and present a refractive index different from the refractive index of adjoining areas for better detectability of said calibration structures for an exposure device;
**characterised in that** said second areas (1) constituting said calibration structures are not exposed by thinning said first or said second substrate.

2. Method according to Claim 1,
**characterised in**
**that** said second areas (1) are produced as recesses in said first layer (3), which form cavities (8, 13) after the joining of the two substrates.

3. Method according to Claim 1,
**characterised in**
**that** said second areas (1) are produced as recesses in said first layer (3), which, in a further step prior to joining said two substrates, are filled with a material (14) presenting a greater difference than air in terms of the refractive index relative to the adjoining regions.

4. Method according to Claim 2 or 3,
**characterised in**
**that** said first regions (2) are produced as recesses constituting a cavity (10) after said two substrates have been joined.

5. Method according to Claim 4,
**characterised in**
**that** said recesses of said second areas (1) are formed in the same step of operation as said recesses in said first areas (2).

6. Method according to any of the Claims 2 to 4,
**characterised in**
**that** said recesses of said second areas (1) are produced to extend down into said first substrate (4, 5, 6).

7. Method according to Claim 6,
**characterised in**
**that** said recesses of said second areas (1) are produced up to a depth penetrating into said first substrate (4, 5, 6), which corresponds to a length of the optical path in the substrate of half a wave length of the monochromatic light to be used for the detection of the calibration structures.

8. Method according to any of the Claims 2 to 5,
**characterised by** the following further step preceding the joining of said two substrates:
ion implantation (15) in said first substrate (4, 5, 7) at the site of said recesses of said second areas (1) up to a depth corresponding to a length of the optical path in said substrate of half a wave length of the monochromatic light to be used for the detection of the calibration structures, with said structured first layer (3) serving as a mask for ion implantation.

9. Method according to any of the Claims 2 to 8,
**characterised in**
**that** two-dimensional calibration structures are produced by groove-shaped recesses in side-by-side arrangement.

10. Method according to any of the Claims 1 to 9,
**characterised in that** said first layer (3) is an oxide and/or nitride layer.

11. Method according to any of the Claims 1 to 10,
**characterised in that** said first and/or second substrate is a silicon substrate.

12. Method according to any of the Claims 1 to 10,
**characterised in that** said first and/or second substrate is an SOI substrate.

13. Method according to any of the Claims 1 to 12,
**characterised in that** the thinning operation is carried out by grinding, polishing, CMP or etching.

## Revendications

1. Procédé à créer des structures d'ajustage dans des substrats semi-conducteurs au cours de la fabrication des composants, comprenant les étapes suivantes :
- prévoir un premier substrat (4, 5, 7) sur lequel une première couche (3) est formée ;
- structurer ladite première couche (3) afin de créer des premières zones (2), qui sont requises pour le fonctionnement des composants ;
- joindre ledit premier substrat (4, 5, 6) à un deuxième substrat (12) d'une telle manière, que ladite première couche (3) soit interposée entre les deux substrats ; et
- amincir ledit premier ou ledit deuxième substrat à une épaisseur résiduelle;
dans lequel lesdites structures d'ajustage sont formées sous forme de deuxièmes zones (1) avant la jonction dudit premier substrat (4, 5, 6) audit deuxième substrat (12), lesquelles pénètrent complètement à travers ladite première couche (3), mais non à travers ledit premier substrat (4), et présentent un indice de réfraction différent de l'indice de réfraction des zones avoisinantes pour une meilleure détectabilité desdites structures d'ajustage pour un dispositif d'exposition;
**caractérisé en ce que** lesdites deuxièmes zones (1), qui constituent lesdites structures d'ajustage, ne sont pas exposées par amincissement dudit premier ou dudit deuxième substrat.

2. Procédé selon la revendication 1,
**caractérisé en ce**
**que** lesdites deuxièmes zones (1) se produisent sous forme de creux dans ladite première couche (3), qui forment des cavités (8, 13) après la jonction des deux substrats.

3. Procédé selon la revendication 1,
**caractérisé en ce**
**que** lesdites deuxièmes zones (1) se produisent sous forme de creux dans ladite première couche (3), qui, au cours d'une autre étape avant la jonction des deux substrats, sont remplis d'un matériau (14) à une plus grande différence que de l'air, en indice de réfraction, relativement aux zones avoisinantes.

4. Procédé selon la revendication 2 ou 3,
**caractérisé en ce**
**que** lesdites premières zones (2) se produisent sous forme de creux, qui constituent une cavité (10), après la jonction des deux substrats.

5. Procédé selon la revendication 4,
**caractérisé en ce**
**que** lesdits creux desdites deuxièmes zones (1) sont formés au cours la même étape de procès que lesdits creux dans lesdites premières zones (2).

6. Procédé selon une quelconque des revendications 2 à 4,
**caractérisé en ce**
**que** lesdits creux desdites deuxièmes zones (1) se produisent d'une telle manière, qu'ils s'étendent dans ledit premier substrat (4, 5, 6).

7. Procédé selon la revendication 6,
**caractérisé en ce**
**que** lesdits creux desdites deuxièmes zones (1) se produisent jusqu'à une telle profondeur, qu'ils pénètrent dans ledit premier substrat (4, 5, 6), qui corresponde à une longueur de trajet optique dans le substrat d'une demie de la longueur d'onde de la lumière monochromatique à utiliser pour la détection des structures d'ajustage.

8. Procédé selon une quelconque des revendications 2a 5,
**caractérisé par** l'étape ultérieure suivante avant la jonction des deux substrats : implantation ionique (15) dans ledit premier substrat (4, 5, 7) au lieu desdits creux des deuxièmes zones (1) jusqu'à une profondeur, qui correspond à une longueur de trajet optique dans ledit substrat d'une demie de la longueur d'onde de la lumière monochromatique à utiliser pour la détection des structures d'ajustage, à ladite première couche (3) structurée faisant fonction d'une masque pour l'implantation ionique.

9. Procédé selon une quelconque des revendications 2 à 8,
**caractérisé en ce**
**que** des structures d'ajustage à deux dimensions sont formées par des creux sous forme de rainures l'un à côté de l'autre.

10. Procédé selon une quelconque des revendications 1 à 9,
**caractérisé en ce que** ladite première couche (3) est une couche d'oxyde et/ou une couche de nitrure.

11. Procédé selon une quelconque des revendications 1 à 10,
**caractérisé en ce que** ledit premier et/ou deuxième substrat est un substrat en silicium.

12. Procédé selon une quelconque des revendications 1 à 10,
**caractérisé en ce que** ledit premier et/ou deuxième substrat est un substrat SOI.

13. Procédé selon une quelconque des revendications 1 à 12,
**caractérisé en ce que** l'amincissement se fait par rectification, polissage, CMP ou gravure.
